# EUROPÄISCHE PATENTSCHRIFT

(11) **EP 0 357 612 B1**
(45) Veröffentlichungstag und Bekanntmachung des Hinweises auf die Patenterteilung: **09.06.1993**
(21) Anmeldenummer: 88902096.2
(22) Anmeldetag: 09.03.1988
(51) Int. Cl.: H01L 25/16, H05K 5/00, H05K 7/20

(54) **ELEKTRISCHES SCHALT- UND STEUERGERÄT**
ELECTRICAL SWITCHING AND CONTROL APPARATUS
APPAREIL ELECTRIQUE DE COMMUTATION ET DE COMMANDE

(30) Priorität: 14.05.1987 DE 3716102
(43) Veröffentlichungstag der Anmeldung: 14.03.1990
(73) Patentinhaber: ROBERT BOSCH GMBH, 70442 Stuttgart (DE)
(72) Erfinder: HAUBNER, Georg, D-8431 Berg (DE); ZÖBL, Hartmut, D-8510 Fürth/Bay. (DE)
(86) Internationale Anmeldenummer: DE8800128
(87) Internationale Veröffentlichungsnummer: WO8809058

(56) Entgegenhaltungen:
- EP-A- 0 093 029
- WO-A-87/01007
- DE-A- 2 806 558
- US-A- 3 805 117
- IBM Technical Disclosure Bulletin, Band 29, Nr. 6, November 1986, (New York, US),"Plastic/metal lead frame from dual inline edge-connected package ,Seiten 2605-2606.Siehe das ganze Dokument.

## Beschreibung

Die Erfindung geht aus von einem elektrischen Schalt- und Steuergerät mit einer Steckkontaktleiste nach der Gattung des Hauptanspruchs. Dabei ist es bekannt, die Steckerstifte derartiger Schalt- und Steuergeräte in einen Stecksockel aus Isolierstoff einzuspritzen und die im Gerätegehäuse liegenden Enden der Steckkontakte mit einer Leiterplatte zu kontaktieren. Die Leiterplatte trägt dabei eine oder mehrere sogenannte Hybridplatten mit elektronischen Schaltungselementen (DE-OS 28 06 558) und/oder diskrete Leistungs-Halbleiter-Bauelemente und dgl.

Bei einer anderen, aus der WO 87/01 007 (R 20142) bekannten Ausführung sind die Leistungs-Bauelemente außerdem auf einer Kühlplatte befestigt, die über eine Isolierfolie auf parallel verlaufende Bereiche der nebeneinander liegenden Steckkontakte aufliegen und so die in den Leistungs-Bauelementen erzeugte Verlustwärme über die Steckkontakte zu den dort angeschlossenen elektrischen Leitungen nach außen abführen. Diese Ausführung ist in ihrer Herstellung aufwendig, da die Leiterplatten, die diskreten Bauelemente und die Kühlplatte vorgefertigt und zusammengebaut werden müssen, bevor sie in das Schalt- und Steuergerät eingesetzt und mit den Anschlußkontakten verlötet werden. Außerdem wird für derartige Ausführungen viel Platz benötigt und sie dürfen bei einer Verwendung in Kraftfahrzeugen aufgrund der relativ großen Abmessungen für die Leiterplatte nicht zu großen Stoß- und Schwingungsbeanspruchungen ausgesetzt sein.

Bei einem aus der US-PS 3 805 117 bekannten gattungsgemäßen Schalt- und Steuergerät werden Hybridplatten ohne Zwischenschaltung von Leiterplatten unmittelbar mit den Steckkontakten des Gerätes kontaktiert. Dort werden Leistungs-Halbleiter-Bauelemente in diskreter Ausführung mit der Hybridplatte kontaktiert, die ihre Wärme entweder über eine massive Einfassung oder über eine weitere Keramikplatte an ein Stablgehäuse des Gerätes abführen. Auch diese Ausführung ist aufwendig, da sie zur Wärmeabführung ein Metallgehäuse benötigt, in dem besondere Isolatoren zur Durchführung der Steckkontakte eingesetzt sind. Außerdem hat das Stahlgehäuse ein hohes Gewicht, was im Kraftfahrzeugbau sehr unerwünscht ist.

Mit der vorliegenden Lösung wird angestrebt, ein elektrisches Schalt- und Steuergerät möglichst kostengünstig und kompakt in einer Hybridschaltung auszuführen, wobei die Leistungs-Bauelemente ebenfalls in Hybridtechnik mit der Hybridplatte bei ausreichender Wärmeabführung zu verkleben sind.

### Vorteile der Erfindung

Das erfindungsgemäße Schalt- und Steuergerät mit den kennzeichnenden Merkmalen des Hauptanspruchs hat den Vorteil, daß zur Wärmeabführung von den Leistungs-Bauelementen keine zusätzlichen Teile mehr benötigt werden. Es entfällt sowohl eine Kühlplatte als auch eine Leiterplatte, wodurch das Gerät kompakt und mit geringem Gewicht herzustellen ist. Da die Wärme über die Steckkontakte nach außen in den angeschlossenen Kabelbaum abgeführt wird, kann auch das Metallgehäuse durch ein wesentlich leichteres und kostengünstiger herstellbares Kunststoffgehäuse ersetzt werden.

Durch die in den Unteransprüchen aufgeführten Maßnahmen sind vorteilhafte Weiterbildungen und Verbesserungen der im Hauptanspruch angegebenen Merkmale möglich. So ist es besonders vorteilhaft, die Hybridplatte stoß- und schwingungssicher im Gerät anzuordnen, indem sie an ihrer einen Längsseite über Anschlußpins mit den Enden der Steckkontakte befestigt ist und an ihrer anderen Längsseite hinter Vorsprünge eines Anschlußsockels festgelegt ist, der die Steckkontakte trägt. Dabei ist es außerdem zweckmäßig, wenn die Hybridplatte auf abgewinkelte Bereiche der Steckkontakte flächig aufliegt. Eine zuverlässige Kontaktierung der Hybridplatte wird dadurch erreicht, daß die im Gehäuse liegenden Enden der Steckkontakte mit Krimpzungen versehen und mit den Anschlußpins der Hybridplatte bzw. mit Anschlußdrähten weiterer elektronischer Bauelemente durch Krimpen kontaktiert sind. Die Wärmeableitung kann auch dadurch gefördert werden, daß die Hybridplatte und die daran anliegenden Bereiche der Steckkontakte über eine Wärmeleitpaste oder einen Kleber miteinander verbunden sind. Für eine schmutz- und feuchtigkeitsdichte Anordnung der Hybridplatte ist es zweckmäßig, daß die Hybridplatte in einem Kragen des Anschlußsockels angeordnet und gemeinsam mit den Enden der Steckkontakte in einer Vergußmasse eingebettet ist.

### Zeichnung

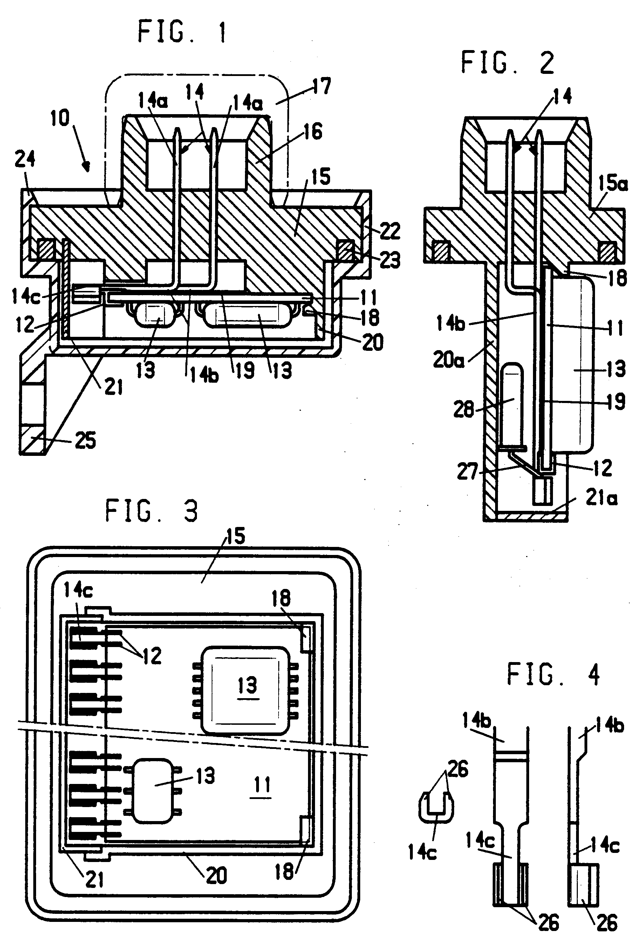

Ausführungsbeispiele der Erfindung sind in der Zeichnung dargestellt und in der nachfolgenden Beschreibung näher erläutert. Es zeigen Figur 1 ein elektrisches Schalt- und Steuergerät mit einem Vielpol-Steckanschluß als erstes Ausführungsbeispiel im Querschnitt, Figur 2 zeigt den Stecksockel des Gerätes nach Figur 1 mit Blick auf die Hybridplatte an der Sockelrückseite, Figur 3 zeigt als weiteres Ausführungsbeispiel einen Stecksockel im Querschnitt mit dazu senkrecht stehender Hybridplatte auf der Rückseite und Figur 4 zeigt ein mit den Anschlußpins der Hybridplatte zu kontaktierende Ende eines Steckkontaktes in mehreren Ansichten.

### Beschreibung der Ausführungsbeispiele

Figur 1 zeigt den Querschnitt eines elektronischen Schalt- und Steuergerätes 10 für ein Kraftfahrzeug, beispielsweise für die Getriebesteuerung in Kraftfahrzeugen. Die Elektronik des Gerätes 10 ist in üblicher Weise in Hybridtechnik auf einer Keramikplatte 11 mit Leiterbahnen verschaltet, die an ihrer linken Längskante - wie Figur 2 zeigt - eine Reihe von Anschlußpins 12 trägt. Des weiteren sind auf der Keramikplatte 11 Leistungs-Halbleiterelemente 13 in bekannter Hybridtechnik aufgeklebt und gebondet. Der elektrische Anschluß des Schalt- und Steuergerätes 10 erfolgt über eine Steckkontaktleiste aus mehreren in zwei Zeilen nebeneinander angeordneten Flachsteckzungen 14, von denen je eine Flachsteckzunge der übereinander angeordneten Zeilen im Querschnitt gemäß Figur 1 dargestellt sind. Die Flachsteckzungen 14 sind als Steckkontake in einem aus Kunststoff hergestellten Stecksockel 15 mit ihrem mittleren Bereich 15a eingespritzt und mit ihren nach außen ragenden Steckerenden von einem Kragen 16 des Stecksockels 15 umgeben. Wie strichpunktiert angedeutet, wird auf diesen Kragen 16 ein vielpoliger Gerätestecker 17 aufgesetzt, an dem die Leitungen eines nicht dargestellten Anschlußkabels angeschlossen sind und die mit entsprechenden Flachsteckhülsen im Gerätestecker 17 zur Herstellung eines lösbaren Steckverbindung mit dem Schalt- und Steuergerät 10 verbunden sind. An der Rückseite des Stecksockels 15 liegen die Steckzungen 14 mit einem abgewinkelten Bereich 14b an der Rückseite der Hybridplatte 11 zur Wärmeabführung flächig an. Mit ihren Enden 14c sind sie schließlich mit jeweils einen Anschlußpin 12 der Hybridplatte 11 durch Krimpen kontaktiert. Dadurch ist die Hybridplatte 11 an ihrer linken Längsseite über die Anschlußpins 12 mit den Enden 14c der Flachsteckzungen 14 befestigt. An ihrer gegenüberliegenden, rechten Längsseite ist die Hybridplatte 11 hinter mehrere Vorsprünge 18 des Anschlußsockels festgelegt. Anstelle der in Figur 2 erkennbaren drei Vorsprünge 18 kann auch ein durchgehender Vorsprung an dieser Stelle vorhanden sein, hinter dem die Hybridplatte 11 vor der Kontaktierung mit den Enden 14c der Flachsteckzunge 14 eingeschoben wird.

Da die Hybridplatte 11 bei diesen Ausführungsbeispiel auf die abgewinkelten Bereiche 14b der Flachsteckzungen 14 flächig aufliegt, kann das Gerät 10 sehr flach und kompakt ausgebildet sein. Eine gute Ableitung der Wärme an den Leistungs-Halbleitern 16 auf der Hybridplatte 11 läßt sich insbesondere dadurch erreichen, daß die Hybridplatte 11 und die daran anliegenden Bereiche 14b der Flachsteckzungen 14 über eine Wärmeleitpaste oder einen Kleber 19 miteinander verbunden sind.

Aus Figur 2 ist in Verbindung mit Figur 1 erkennbar, daß die ganze Hybridplatte 11 mit samt ihren Anschlüssen an die Enden 14c der Flachsteckzungen 14 von einen Kragen 20 an der Rückseite des Stecksockels 15 umgeben ist, wobei auf der linken Seite im Bereich der Krimpverbindungen der Kragen nach der Kontaktierung der Hybridplatte 11 mit den Flachsteckzungen 14 durch einen Rahmen 21 aus Kunststoff geschlossen wird, um dann die ganze Hybridschaltung mit einem Gießharz, Silikon oder einer anderen isolierenden Vergußmasse wasserdicht einzubetten. Der Stecksockel 15 mit der Hybridplatte 11 ist schließlich von einem Isolierstoffgehäuse 22 umgeben, die durch Ultraschall auf den Stecksockel 15 aufgeschweißt werden kann oder, wie in Figur 1 dargestellt ist, mittels einer Gummidichtung 23 auf den Stecksockel 15 aufgesetzt und an seiner Oberseite durch Rastnasen 24 aufgeschnappt wird. Bei einer solchen wassergeschützten Ausführung kann die Entlüftung über den Stecksockel 15 und dem Gerätestecker 17 mit angeschlossenem Kabel oder über ein im Gehäuse 22 einzusetzendes, nicht dargestelltes Druckausgleichselement erfolgen. Eine am Isolierstoffgehäuse 22 angeformte Konsole 25 dient zur Befestigung des Schalt- und Steuergerätes 10. Als Gehäuse kann auch ein Metallgehäuse, z. B. ein Aluminium-Druckguß oder ein Blechgehäuse verwendet werden, wobei im letzteren Fall die Konsole 25 am Gehäuse angeschweißt wird.

Figur 3 zeigt in einem weiteren Ausführungsbeispiel, bei der für gleiche Teile gleiche Bezugszahlen wie in Figur 1 und 2 verwendet werden, einen Stecksockel 15a mit zwei übereinander angeordneten Reihen von Flachsteckzungen 14, wobei die Hybridplatte 11 an der Rückseite des Stecksockels 15a senkrecht von diesem absteht. Auch hier trägt die Hybridplatte 11 flächig auf ihr aufliegende Leistungs-Halbleiterelemente 13, deren Verlustwärme über die Hybridplatte 11 zu den Steckkontakten in Form von Flachsteckern 14 abgeführt werden soll. Zu diesem Zweck ist die Rückseite der Hybridplatte 11 auf die Bereiche 14b der nebeneinanderliegenden Flachsteckzungen 14 flächig aufgesetzt. Auch hier wird der Wärmeübergang durch Verwendung eines Wärmeleitklebers bzw. einer Wärmeleitpaste zwischen der Hybridplatte 11 und den Bereichen 14b der Flachsteckzungen 14 noch verstärkt. Die im nicht dargestellten Gehäuse des Schalt- und Steuergerätes liegenden Enden 14c der Flachsteckzungen 14 sind auch hier mit Krimpzungen 26 versehen, von denen eine in Figur 4 in verschiedenen Darstellungen vergrößert erkennbar ist. In diese Krimpzungen 26 wird jeweils ein Anschlußpin 12 der Hybridplatte 11 oder ein Anschlußdraht 27 eines weiteren elektronischen Bauelementes 28, z.B. eines Schwingquarzes durch Krimpen kontaktiert. Dieses Bauelement 28 kann durch nicht erkennbare Kunststoffedern am Stecksockel bzw. an den Kragen 20a befestigt sein, der die Hybridplatte 11 einfaßt und der im Bereich der mit den Anschlußpins 12 versehenen Kontaktseite der Hybridplatte 11 durch einen Isolierstoffrahmen 21a zum Eingießen von Vergußmasse oder dgl. abgeschlossen wird.

Auch hier wird die Hybridplatte 11 direkt auf eine Steckerleiste geklemmt bzw. darauf geklebt, so daß durch die große Auflagefläche der Hybridplatte 11 auf den Steckerbereichen 14b eine gute Wärmeableitung nach außen auf einen Kabelbaum gewährleistet ist. Dabei sind die Anschlußpins 12 der Hybridplatte 11 jeweils einem Flachstecker 14 direkt zugeordnet. Durch die gute Wärmeableitung können Leistungs-Hableiterschalter ohne besondere Kühlplatten unmittelbar auf die Hybridplatte 11 aufgebracht werden. Anstelle von Krimpverbindungen zwischen Hybridplatte 11 und Flachsteckzungen 14 kann bei anderer Ausführung der Steckkontakte und der Kontakte an der Hybridplatte 11 eine elektrische Verbindung auch durch Tauchlöten, Handlöten, Schweißen und dgl. erfolgen.

## Patentansprüche

1. Elektrisches Schalt- und Steuergerät mit einer Steckkontaktleiste aus mehreren nebeneinander angeordneten Steckkontakten für den elektrischen Anschluß und mit einer Hybridplatte, vorzugsweise aus Keramik, mit mehreren wärmeabgebenden elektronischen Leistungs-Bauelementen, wobei die Hybridplatte an einer ihrer Längs- oder Schmalseiten über Anschlußteile mit den Steckkontakten galvanisch fest verbunden ist, dadurch gekennzeichnet, daß die Steckkontakte (14) mit ihren im Gehäuse (22) des Schalt- und Steuergerätes (10) liegenden flächigen Bereichen (14b) an der Rückseite der Hybridplatte (11) zur Wärmeabführung von den flächig auf der Hybridplatte (11) befestigten Leistungs-Bauelementen (13) anliegen und an den Enden (14c) dieser flächigen Bereiche (14b) mit den Anschlußteilen (12) der Hybridplatte (11) direkt kontaktiert sind.

2. Schalt- und Steuergerät nach Anspruch 1, dadurch gekennzeichnet, daß die Hybridplatte (11), die an ihrer einen Längsseite über Anschlußpins (12) mit den Enden (14c) der Steckkontakte (14) befestigt ist, an ihrer anderen Längsseite hinter Vorsprünge (18) eines Anschlußsockels (15) festgelegt ist, welcher die Steckkontakte (14) trägt.

3. Schalt- und Steuergerät nach Anspruch 2, dadurch gekennzeichnet, daß die Hybridplatte (11) auf abgewinkelte Bereiche (14b) der Steckkontakte (14) flächig aufliegt.

4. Schalt- und Steuergerät nach Anspruch 2, dadurch gekennzeichnet, daß die im Gehäuse (22) liegenden Enden (14c) der Steckkontakte (14) mit Krimpzungen (26) versehen und mit den Anschlußpins (12) der Hybridplatte (11) bzw. mit Anschlußdrähten (27) weiterer elektronischer Bauelemente (28) durch Krimpen kontaktiert sind.

5. Schalt- und Steuergerät nach Anspruch 2, dadurch gekennzeichnet, daß die Hybridplatte (11) und die daran anliegenden Bereiche (14b) der Steckkontakte (14) über eine Wärmeleitpaste (19) bzw. einen Wärmeleitkleber miteinander verbunden sind.

6. Schalt- und Steuergerät nach Anspruch 2, dadurch gekennzeichnet, daßdie Hybridplatte (11) in einem Kragen (20) des Anschlußsockels (15) angeordnet und gemeinsam mit den Enden (14c) der Steckkontakte (14) in einer Vergußmasse eingebettet ist.

## Claims

1. Electrical switching and control device having a multipole connector made from a plurality of juxtaposed plug-in contacts for the electrical connection, and a hybrid plate, preferably made from ceramic, having a plurality of heat-dissipating electronic power components, the hybrid plate being permanently connected electrically to the plug-in contacts via connecting parts on its long or narrow sides, and the planar regions, located in the housing of the switching and control device, of the plug-in contacts bearing against the rear of the hybrid plate in order to dissipate heat from the power components attached in a planar fashion to the hybrid plate, characterised in that at the ends (14c) of these planar regions (14b) the plug-in contacts (14) directly contact the connecting parts (12) of the hybrid plate (11).

2. Switching and control device according to Claim 1, characterised in that the hybrid plate (11), which is attached on its one long side to the ends (14c) of the plug-in contacts (14) via connecting pins (12), is fixed on its other long side behind projections (18) of a connecting base (15) which support the plug-in contacts (14).

3. Switching and control device according to Claim 2, characterised in that the hybrid plate (11) rests in a planar fashion on bent regions (14b) of the plug-in contacts (14).

4. Switching and control device according to Claim 2, characterised in that the ends (14c), located in the housing (22), of the plug-in contacts (14) are provided with crimping tongues (26), and further electronic components (28) are contacted by crimping to the connecting pins (12) of the hybrid plate (11) or to connecting wires (27).

5. Switching and control device according to Claim 2, characterised in that the hybrid plate (11) and the regions (14b), adjacent thereto, of the plug-in contacts (14) are connected to one another via a heat transfer compound (19) or a heat transfer adhesive.

6. Switching and control device according to Claim 2, characterised in that the hybrid plate (11) is arranged in a collar (20) of the connecting base (15) and is embedded in a casting compound together with the ends (14c) of the plug-in contacts (14).

## Revendications

1. Appareil électrique de commutation et de commande avec un connecteur multibroches à partir de plusieurs contacts à broches disposés les uns à côté des autres pour le raccordement électrique et avec une plaque hybride, de préférence en céramique, avec plusieurs composants électroniques de puissance dégageant de la chaleur, la plaque hybride étant reliée galvaniquement de façon solidaire avec les contacts à fiches sur l'un de ses côtés longitudinaux ou étroits par des pièces de raccordement, et les zones planes se trouvant dans le boîtier de l'appareil de commutation et de commande, des contacts à fiches reposant sur la face arrière de la plaque hybride pour évacuer la chaleur des composants de puissance fixés à plat sur la plaque hybride, appareil électrique de commutation et de commande caractérisé en ce que les contacts à fiches (14) viennent directement en contact aux extrémités (14c) de ces zones planes (14b) avec les pièces de raccordement (12) de la plaque hybride (11).

2. Appareil électrique de commutation et de commande selon la revendication 1, caractérisé en ce que la plaque hybride (11), qui est fixée à l'une de ses extrémités longitudinales par des broches de raccordement (12) aux extrémités (14c) des contacts à fiches (14), est fixe par son autre côté longitudinal derrière des saillies (18) d'un socle de raccordement (15) qui porte les contacts à fiches (14).

3. Appareil de commutation et de commande selon la revendication 2, caractérisé en ce que la plaque hybride (11) repose à plat sur des zones coudées (14b) des contacts à fiches (14).

4. Appareil de commutation et de commande selon la revendication 2, caractérisé en ce que les extrémités (14c), se trouvant dans le boîtier (22), des contacts à fiches (14), sont pourvues de languettes d'écrasement et sont mises en contact avec les broches de raccordement (12) de la plaque hybride (11) ou avec les fils de raccordement (27) d'autres composants électroniques (28) par écrasement.

5. Appareil de commutation et de commande selon la revendication 2, caractérisé en ce que la plaque hybride (11) et les zones (14b) qui reposent sur celle-ci des contacts à fiches (14) sont reliées ensemble par une pâte conductrice de la chaleur (19) ou une colle conductrice de la chaleur.

6. Appareil de commutation et de commande selon la revendication 2, caractérisé en ce que la plaque hybride (11) est disposée dans une collerette (20) du socle de raccordement (15) et est noyée en même temps que les extrémités (14c) des contacts à fiches (14) dans une masse de scellement.
